# FASCICULE DE BREVET EUROPEEN

(11) **EP 3 535 780 B1**
(45) Date de publication et mention de la délivrance du brevet: **27.03.2024**
(21) Numéro de dépôt: 17797603.2
(22) Date de dépôt: 06.11.2017
(51) Int. Cl.: H01L 21/673, G01M 3/32

(54) **DISPOSITIF ET PROCÉDÉ DE CONTRÔLE DE L'ÉTANCHÉITÉ D'UNE ENCEINTE DE TRANSPORT POUR LE CONVOYAGE ET LE STOCKAGE ATMOSPHÉRIQUE DE SUBSTRATS SEMI-CONDUCTEURS**
VORRICHTUNG UND VERFAHREN ZUR ÜBERWACHUNG DER DICHTIGKEIT EINES TRANSPORTBEHÄLTERS ZUR ATMOSPHÄRISCHEN FÖRDERUNG UND LAGERUNG VON HALBLEITERSUBSTRATEN
DEVICE AND METHOD FOR MONITORING THE LEAK-TIGHTNESS OF A TRANSPORT ENCLOSURE FOR THE ATMOSPHERIC CONVEYANCE AND STORAGE OF SEMICONDUCTOR SUBSTRATES

(30) Priorité: 07.11.2016 FR 1660750
(43) Date de publication de la demande: 11.09.2019
(73) Titulaire: Pfeiffer Vacuum, 74000 Annecy (FR)
(72) Inventeur: BELLET, Bertrand, 74000 Annecy (FR); BOUNOUAR, Julien, 74000 Annecy (FR); CHAPEL, Nicolas, 74150 Sales (FR)
(74) Mandataire: Innovincia
(86) Numéro de dépôt international: PCT/EP2017/078367
(87) Numéro de publication internationale: WO 2018/083312

(56) Documents cités:
- WO-A1-2012/108418
- WO-A1-2016/035675
- JP-A- 2003 315 197

## Description

La présente invention concerne un dispositif de contrôle de l'étanchéité d'au moins une enceinte de transport pour le convoyage et le stockage atmosphérique de substrats semi-conducteurs. La présente invention concerne également un procédé de contrôle de l'étanchéité d'au moins une enceinte de transport.

Dans l'industrie de fabrication de semi-conducteurs, des enceintes de transport tels que des FOUP (« Front Opening Unified Pod » en anglais), permettent de transporter les substrats, tels que des plaquettes semi-conductrices, d'un équipement à l'autre ou de stocker les substrats entre deux étapes de fabrication. Ces enceintes de transport déterminent un espace confiné sous pression atmosphérique, séparé de l'environnement d'utilisation et de transport du substrat, pour le transport et le stockage d'un ou de plusieurs substrats dans les salles blanches, dans lesquelles l'atmosphère intérieure est maintenue avec un taux de contamination très bas. Ces enceintes de transport sont des éléments standardisés dont l'ouverture et la fermeture peuvent être gérées de manière automatique directement par les équipements de fabrication.

Les enceintes de transport comportent une enveloppe rigide périphérique dont l'ouverture peut être obturée par une porte amovible, un joint de porte étant interposé entre la porte et l'enveloppe. L'enceinte de transport n'est cependant pas totalement étanche car des ports de ventilation (« breathing port » en anglais) sont ménagés dans l'enveloppe ou la porte pour permettre l'équilibrage des pressions entre l'intérieur et l'extérieur de l'enceinte.

Pour diminuer encore les risques de contamination à l'intérieur de ces enceintes, il est actuellement préconisé de purger régulièrement l'atmosphère interne de ces enceintes.

Des développements récents prévoient en outre l'agencement de clapets anti-retour dans les ports de ventilation de certaines enceintes de transport, les clapets anti-retour étant montés en série des filtres. Les clapets anti-retour permettent la fermeture presque étanche des enceintes pour conserver le plus longtemps possible l'atmosphère interne des enceintes en légère surpression de gaz de purge sans échange de gaz avec l'extérieur.

Cette augmentation du degré d'étanchéité au niveau des ports de ventilation rend le niveau d'étanchéité de la porte déterminant. En effet, si l'étanchéité de la porte n'est pas garantie, du gaz non filtré peut entrer dans l'enceinte de transport, ce qui est particulièrement dommageable pour les substrats. Des mesures ont en effet établi une corrélation entre le niveau d'étanchéité de la porte de l'enceinte de transport et le niveau de contamination en particules des substrats contenus dans ces enceintes. Le niveau d'étanchéité de la porte est donc directement lié au rendement de production. Toutefois, aucun moyen actuel ne permet la réalisation d'un contrôle de l'étanchéité de la porte d'une enceinte de transport de manière automatique permettant de réaliser un contrôle d'étanchéité en cours de production.

WO 2012/108418 décrit un dispositif de purge selon l'art antérieur.

Un des buts de la présente invention est donc de proposer un dispositif de contrôle de l'étanchéité d'au moins une enceinte de transport pour le convoyage et le stockage atmosphérique de substrats semi-conducteurs pouvant être automatisé pour réaliser des contrôles d'étanchéité fiables, rapides et en cours de production.

A cet effet, l'invention a pour objet un dispositif de contrôle de l'étanchéité d'au moins une enceinte de transport pour le convoyage et le stockage atmosphérique de substrats semi-conducteurs selon la revendication 1.

Le dispositif de contrôle permet ainsi de contrôler l'étanchéité de la porte de l'enceinte en accédant à l'atmosphère intérieure de l'enceinte de transport depuis l'extérieur de celle-ci, de manière étanche et sans modification de l'enceinte qui reste standard. L'étanchéité de fermeture de l'enceinte de transport peut donc être contrôlée en cours de production, de manière entièrement automatisée et alors qu'elle contient des substrats semi-conducteurs. Il est alors possible de réaliser un contrôle d'étanchéité en quelques minutes, tel qu'en moins de cinq minutes, pour une gamme de fuites de conductance allant de 0.01l/s à quelques l/s, la conductance étant le rapport du débit de fuite sur la différence de pression générant cette fuite.

La tête de mesure peut être configurée pour s'engager dans un port de ventilation de l'enceinte de transport en repoussant le clapet anti-retour entrant lorsque le port de ventilation est muni d'un clapet anti-retour entrant. La tête de mesure permet ainsi de raccorder une ligne de mesure à un port de ventilation de l'enceinte de transport en ouvrant les clapets anti-retour éventuellement présents sur l'enceinte de transport. Le maintien ouvert des clapets anti-retour entrants par les têtes de mesure permet notamment d'injecter des flux de gaz contrôlés dans l'enceinte de transport, en s'affranchissant de la variabilité des organes élastiques des clapets qui pourraient augmenter l'incertitude des mesures, la raideur des organes élastiques pouvant présenter de fortes dispersions d'une enceinte de transport à l'autre. Ce maintien ouvert des clapets permet également d'éviter les effets de vibration des clapets lorsque ceux-ci prennent un état instable entre la position ouverte et la position fermée.

Au moins une tête de connexion peut être formée par une tête obstruante comportant un élément d'étanchéité borgne configuré pour obturer un port de ventilation de l'enceinte de transport, tous les ports de ventilation de l'enceinte de transport étant soit engagés par une tête de mesure, soit obturés par une tête obstruante.

Ainsi, toutes les fuites éventuelles de gaz autres que celles situées entre la porte et l'enveloppe de l'enceinte de transport sont maîtrisées, c'est à dire qu'elles sont soit obstruées, soit raccordées à une tête de mesure, de sorte que le contrôle d'étanchéité de l'enceinte de transport reflète uniquement le contrôle de l'étanchéité de fermeture de la porte de l'enceinte.

Selon une ou plusieurs caractéristiques du dispositif de contrôle, prise seule ou en combinaison :
- le au moins un élément d'étanchéité périphérique est élastique et au moins partiellement comprimé ou déformé lorsque l'enceinte de transport est accouplée à l'interface,
- le au moins un élément d'étanchéité borgne est élastique et au moins partiellement comprimé ou déformé lorsque l'enceinte de transport est accouplée à l'interface,
- l'interface comporte au moins un moyen de maintien configuré pour maintenir l'enceinte de transport,
- l'interface comporte un moyen de positionnement configuré pour positionner et supporter l'enceinte de transport,
- le moyen de positionnement comporte trois pions de centrage faisant saillie du plateau de l'interface,
- les pions de centrage sont configurés pour s'engager dans trois cavités complémentaires, ménagées dans le fond de l'enceinte de transport,
- les têtes de connexion sont mobiles,
- l'interface comporte en outre au moins un actionneur de têtes configuré pour déplacer les têtes de connexion entre une position de retrait et une position saillante de contrôle de l'étanchéité,
- la course de déplacement de l'actionneur de têtes est supérieure à 0,5mm,
- les têtes de connexion sont fixes et font saillie de l'interface,
- les éléments d'étanchéité périphérique et borgne à l'état non comprimé ou non déformés font saillie d'un plateau de l'interface au-delà de l'extrémité du moyen de positionnement,
- le au moins un élément d'étanchéité périphérique et/ou l'élément d'étanchéité borgne comporte une ventouse, un joint torique ou un joint à lèvres ou un soufflet,
- l'interface comporte deux têtes de mesure et deux têtes obstruantes,
- le dispositif de contrôle comporte au moins une ligne de mesure reliée à un embout d'une tête de mesure, la ligne de mesure comportant un dispositif de contrôle du débit et/ou un capteur de pression,
- la ligne de mesure comporte au moins un orifice calibré d'auto-contrôle monté en dérivation de la tête de mesure et une vanne trois voies apte à mettre en communication le dispositif de contrôle du débit et le capteur de pression de la ligne de mesure, avec le au moins un orifice calibré d'auto-contrôle en étant isolé de la tête de mesure,
- le dispositif de contrôle comporte une ligne de prélèvement reliée à l'embout d'une tête de mesure, la ligne de prélèvement comportant une pompe de prélèvement,
- le dispositif de contrôle comporte une ligne d'étalonnage reliée à l'embout d'une tête de mesure, la ligne d'étalonnage comportant au moins un orifice calibré d'étalonnage.

L'invention a aussi pour objet un procédé de contrôle de l'étanchéité d'au moins une enceinte de transport pour le convoyage et le stockage atmosphérique de substrats semi-conducteurs au moyen d'un dispositif de contrôle tel que décrit précédemment et selon la revendication 11.

Selon un exemple de réalisation, tous les ports de ventilation de l'enceinte de transport sont, soit engagés par une tête de mesure, soit obturés par une tête obstruante de l'interface, au moins une tête de connexion formée par une tête obstruante obturant un port de ventilation de l'enceinte de transport.

Selon une ou plusieurs caractéristiques du procédé de contrôle, prise seule ou en combinaison :
- le au moins un élément d'étanchéité périphérique est au moins partiellement comprimé ou déformé lorsque l'enceinte de transport est accouplée à l'interface,
- le au moins un élément d'étanchéité borgne est au moins partiellement comprimé ou déformé lorsque l'enceinte de transport est accouplée à l'interface,
- on injecte un flux de gaz contrôlé dans une ligne de mesure raccordée à une tête de mesure engagée dans un port de ventilation de l'enceinte de transport accouplée à l'interface, puis on arrête l'injection et on mesure la descente en pression dans la ligne de mesure,
- on injecte un flux de gaz constant dans une ligne de mesure raccordée à une tête de mesure engagée dans un port de ventilation de l'enceinte de transport accouplée à l'interface, en mesurant l'évolution de la pression au cours du temps dans la ligne de mesure,
- le procédé de contrôle comprend une étape préalable de conditionnement dans laquelle on établit une pression initiale prédéterminée dans une ligne de mesure raccordée à une tête de mesure engagée dans un port de ventilation de l'enceinte de transport accouplée à l'interface,
- le procédé de contrôle comporte une étape de calibration dans laquelle une ligne d'étalonnage est raccordée à l'enceinte de transport par une tête de mesure engagée dans un port de ventilation de l'enceinte de transport accouplée à l'interface pour générer une fuite calibrée et on mesure la pression dans une ligne de mesure raccordée à une tête de mesure engagée dans un port de ventilation de l'enceinte de transport accouplée à l'interface,
- le procédé de contrôle comporte une étape d'auto-contrôle dans laquelle on mesure la pression dans une ligne de mesure comportant un orifice calibré d'auto-contrôle monté en dérivation de la tête de mesure, l'orifice calibré d'auto-contrôle étant mis en communication avec le dispositif de contrôle du débit et le capteur de pression de la ligne de mesure en étant isolé de la tête de mesure.

D'autres caractéristiques et avantages de l'invention ressortiront de la description suivante, donnée à titre d'exemple, sans caractère limitatif, en regard des dessins annexés sur lesquels:
- la figure 1 montre une vue schématique en coupe et de côté d'un exemple d'enceinte de transport ayant des clapets anti-retour d'entrée et de sortie représentés en position fermée ainsi qu'un dispositif de contrôle de l'étanchéité de l'enceinte de transport,
- la figure 2a est une vue schématique d'un fond de l'enveloppe de l'enceinte de transport de la figure 1,
- la figure 2b est une vue schématique d'un autre exemple de fond d'enceinte de transport,
- la figure 2c est une vue schématique d'un autre exemple de fond d'enceinte de transport,
- la figure 3a montre une vue sensiblement de dessus de l'interface du dispositif de contrôle de la figure 1 en position de retrait,
- la figure 3b est une vue similaire à la figure 3a avec deux têtes de mesure et deux têtes obstruantes de l'interface en position de saillie,
- la figure 4 est une vue similaire à la figure 1, montrant une ligne d'étalonnage de l'interface,
- la figure 5 montre différentes étapes d'un procédé de contrôle de l'étanchéité d'une enceinte de transport,
- la figure 6 est une vue similaire à la figure 1, montrant l'enceinte de transport positionnée et maintenue à l'interface,
- la figure 7 est une vue similaire à la figure 6, montrant l'enceinte de transport accouplée à l'interface,
- la figure 8 est un graphique montrant l'évolution de la pression au cours du temps pour un contrôle de l'étanchéité réalisé selon le procédé de la figure 5, et
- la figure 9 est un graphique montrant l'évolution de la pression au cours du temps pour deux injections de flux de gaz constants et distincts au cours d'un contrôle de l'étanchéité réalisé selon une autre méthode.

Sur ces figures, les éléments identiques portent les mêmes numéros de référence. Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées ou interchangées pour fournir d'autres réalisations.

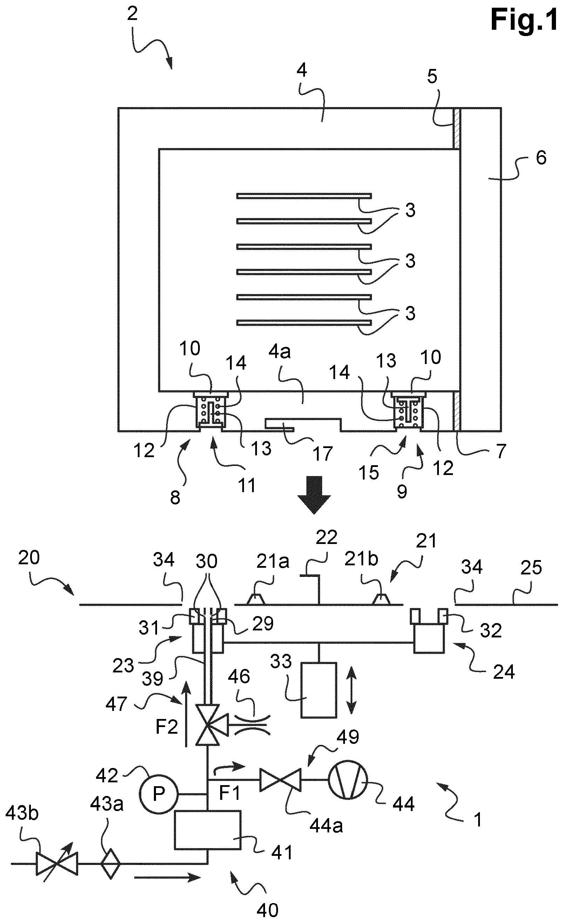

La figure 1 montre une vue schématique en coupe et de côté d'un dispositif de contrôle 1 de l'étanchéité d'au moins une enceinte de transport 2.

L'enceinte de transport 2 permet le convoyage et le stockage d'au moins un substrat semi-conducteur 3, tel que des plaquettes (« wafers » en anglais) ou des photomasques, entre les étapes de fabrication de semi-conducteurs. L'atmosphère intérieure des enceintes de transport 2 est à pression atmosphérique d'air ou d'azote. Il s'agit par exemple de boîtes normalisées à ouverture latérale de type FOUP (« Front Opening Unified Pod » en anglais) ou de boîtes normalisées d'ouverture latérale de type MAC (« Multi Application Carrier » en anglais) ou de boîtes à ouverture inférieure de type SMIF (« Standard Mechanical InterFace » en anglais) ou de boites de transport pour photomasques de type RSP (« Reticle SMIF Pod » en anglais).

L'enceinte de transport 2 comporte une enveloppe 4 rigide, en matériau plastique, présentant une ouverture 5 et une porte amovible 6 comportant un joint d'étanchéité périphérique 7, la porte amovible 6 permettant d'obturer l'ouverture 5. L'ouverture 5 peut être latérale (figure 1) ou inférieure.

L'enceinte de transport 2 comporte au moins deux ports de ventilation 8, 9, chaque port de ventilation 8, 9 comportant un orifice 12 ménagé dans le fond 4a de l'enveloppe 4 dans le cas d'une enceinte à ouverture latérale ou ménagé dans la porte 6 dans le cas d'une enceinte à ouverture par le fond.

Chaque port de ventilation 8, 9 comporte un filtre 10 à particules agencé dans l'orifice 12, empêchant l'entrée de particules à l'intérieur de l'enceinte de transport 2.

Les ports de ventilation 8, 9 peuvent être seulement formés par un orifice 12 pourvu d'un filtre 10, le flux de gaz pouvant entrer et sortir simultanément et indifféremment dans chaque port de ventilation de l'enceinte 2.

D'autres exemples d'enceintes de transport 2 présentent au moins un port de ventilation 8 comportant un clapet anti-retour entrant 11 (appelé « port d'entrée » par la suite) et au moins un port de ventilation 9 comportant un clapet anti-retour sortant 15 (appelé « port de sortie » par la suite). Les clapets 11, 15 sont agencés dans un orifice 12 respectif, en amont ou en aval du filtre 10.

Les clapets anti-retour sortant 15 s'ouvrent en cas de surplus gazeux à l'intérieur de l'enceinte de transport 2 par rapport à la pression atmosphérique extérieure et les clapets anti-retour entrant 11 à l'inverse, s'ouvrent en cas de dépression à l'intérieur de l'enceinte 2.

Un gaz de purge peut être injecté dans l'enceinte de transport 2 au niveau d'un clapet anti-retour entrant 11, le surplus d'air s'évacuant par un clapet anti-retour sortant 15. Il est ainsi possible de purger l'atmosphère interne de l'enceinte de transport 2 sans ouverture et sans modification de l'enceinte 2 et donc, en cours de production.

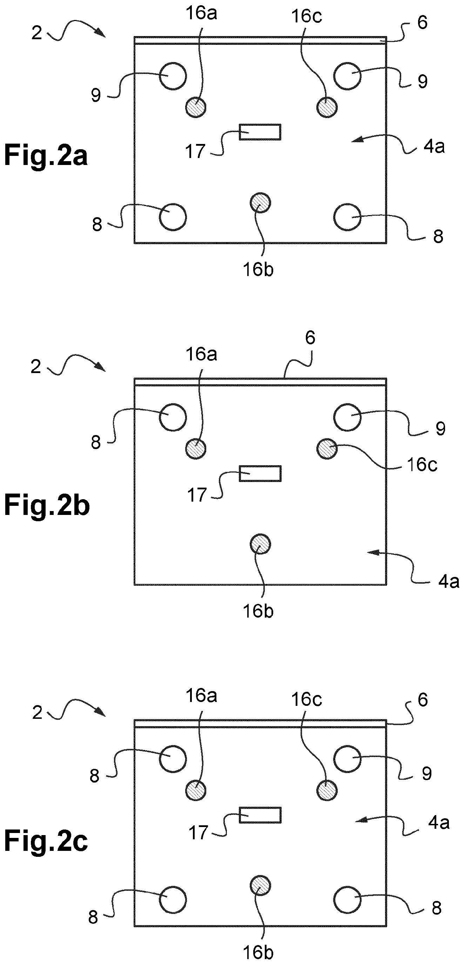

L'enceinte de transport 2 comporte par exemple deux ports d'entrée 8 et deux ports de sortie 9 (figure 2a). Les quatre ports d'entrée et de sortie 8, 9 peuvent être agencés aux quatre coins du fond 4a de l'enveloppe 4 de l'enceinte 2. Pour une enceinte de transport 2 à ouverture 5 latérale, les ports de sortie 9 sont par exemple situés aux coins les plus proches de la porte 6.

D'autres réalisations sont envisageables. Par exemple, pour une enceinte de transport 2 à ouverture 5 latérale, l'enceinte de transport 2 peut comporter un unique port d'entrée 8 et un unique port de sortie 9, par exemple situés aux deux coins du fond 4a, à proximité de la porte 6 (figure 2b). Selon un autre exemple, l'enceinte de transport 2 comporte trois ports d'entrée 8 et un unique port de sortie 9, le port de sortie 9 étant par exemple agencé dans un coin proche de la porte 6.

Selon un exemple de réalisation, le clapet anti-retour entrant 11 comporte un obturateur mobile 13 et un organe élastique 14 (figure 1). L'obturateur 13 est mobile entre une position ouverte et une position fermée dans laquelle il obture l'orifice 12. Il comporte par exemple un disque complémentaire d'un palier cylindrique de l'orifice 12. L'organe élastique 14, tel qu'un ressort de compression, sollicite l'obturateur mobile 13 en position fermée.

L'ouverture du clapet anti-retour entrant 11 permet l'entrée d'un gaz dans l'enceinte de transport 2 sous l'exercice d'un effort extérieur à l'enceinte de transport 2, la position du clapet étant déterminée par la différence de pression amont/aval du clapet. Lorsque la différence de pression entre la pression extérieure et la pression intérieure de l'enceinte de transport 2 est supérieure à un seuil de tarage du clapet, l'obturateur mobile 13 se déplace à l'encontre de l'organe élastique 14 en position ouverte et du gaz peut entrer dans l'enceinte de transport 2.

Le port de sortie 9 se différencie du port d'entrée 8 par le fait que son ouverture permet la sortie d'un gaz de l'enceinte de transport 2, le clapet anti-retour de sortie 15 s'ouvrant sous l'exercice d'un effort exercé à l'intérieur de l'enceinte de transport 2. Ainsi, lorsque la différence de pression entre la pression intérieure et la pression extérieure de l'enceinte de transport 2 est supérieure à un seuil de tarage du clapet, l'obturateur mobile 13 se déplace à l'encontre de l'organe élastique 14 en position ouverte et du gaz peut sortir de l'enceinte de transport 2.

Les orifices 12 et les filtres 10 du au moins un port d'entrée 8 et du au moins un port de sortie 9 peuvent être identiques. Les obturateurs mobiles 13 et les organes élastiques 14 du clapet anti-retour entrant 11 et du clapet anti-retour de sortie 15 peuvent également être les mêmes, l'obturateur mobile 13 du clapet anti-retour entrant 11 étant agencé en position inversée par rapport à l'obturateur mobile 13 du clapet anti-retour de sortie 15.

Le dispositif de contrôle 1 de l'étanchéité d'au moins une enceinte de transport 2 comporte au moins une interface 20 configurée pour s'accoupler à l'enceinte de transport 2.

L'interface 20 comprend au moins deux têtes de connexion dont au moins une tête de mesure 23 est configurée pour s'engager dans un orifice 12 d'un port de ventilation 8 de l'enceinte de transport 2. Les têtes de connexion peuvent toutes être des têtes de mesure 23.

Au moins une tête de connexion peut être formée par une tête obstruante 24. L'interface 20 comprend alors au moins une tête de mesure 23 et au moins une tête obstruante 24.

La tête de mesure 23 comporte un embout 29 saillant, débouchant par au moins un orifice 30, ainsi qu'un élément d'étanchéité périphérique 31 entourant l'embout 29 tel qu'en amont du au moins un orifice 30. Le au moins un orifice 30 est interposé entre l'extrémité de l'embout 29 et l'élément d'étanchéité périphérique 31.

L'embout 29 est rigide. C'est par exemple un tube, par exemple en matériau métallique. Il fait saillie dans une direction axiale, destiné à être perpendiculaire à la paroi de l'enceinte de transport 2 accouplée à l'interface 20. Deux orifices 30 débouchent par exemple latéralement de l'extrémité de l'embout 29, les orifices 30 étant par exemple diamétralement opposés.

L'élément d'étanchéité périphérique 31 permet la circulation étanche des gaz entre l'embout 29 et le port de ventilation 8 de l'enceinte de transport 2 accouplée, via le au moins un orifice 30.

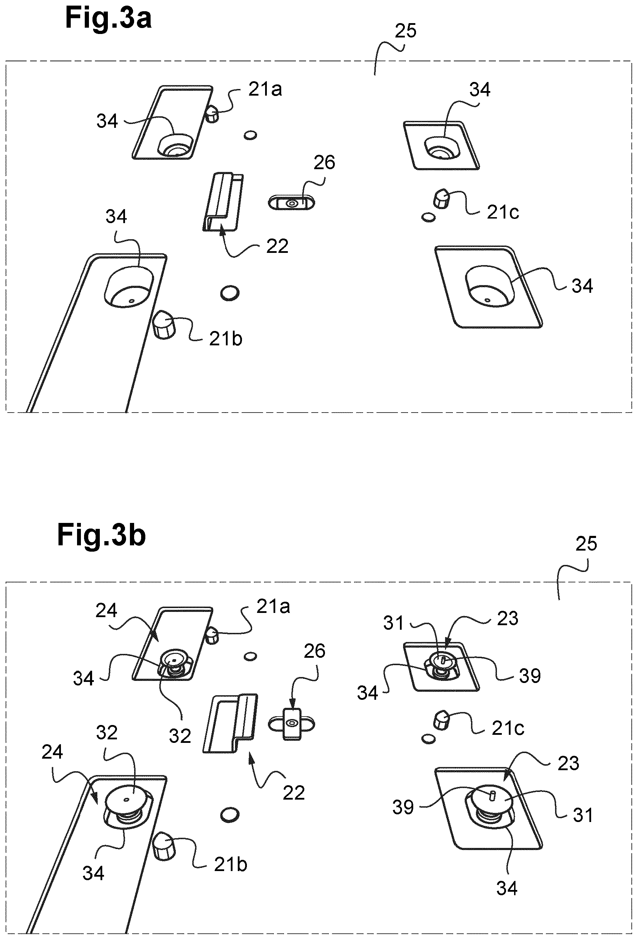

L'élément d'étanchéité périphérique 31 est par exemple en matériau élastique, tel qu'en silicone. C'est par exemple une ventouse (figure 3b), un joint torique ou un joint à lèvres ou un soufflet. La ventouse permet d'obtenir de manière simple une très bonne étanchéité, le poids de l'enceinte de transport 2 pouvant suffire à déformer la ventouse saillant d'un plateau 25 horizontal.

L'élément d'étanchéité périphérique 31 peut également être en matériau rigide, tel qu'en matériau PEEK, l'étanchéité pouvant être obtenue par compression de l'organe élastique 14 dans le cas où le port d'entrée 8 comporte un clapet anti-retour entrant 11.

La tête de mesure 23 est configurée pour s'engager dans un orifice 12 d'un port de ventilation 8 de l'enceinte de transport 2 notamment en repoussant l'obturateur mobile 13 du clapet anti-retour entrant 11 lorsque le port de ventilation 8 est muni d'un clapet anti-retour entrant 11 et par exemple en comprimant ou en déformant au moins partiellement l'élément d'étanchéité périphérique 31.

Ainsi, lorsque la tête de mesure 23 est engagée dans un port de ventilation 8 de l'enceinte 2 munie d'un clapet anti-retour entrant 11, l'extrémité de l'embout 29 rigide appuie sur l'obturateur mobile 13 pour le repousser.

La tête de mesure 23 peut ainsi permettre de raccorder une ligne de mesure 40 à un port de ventilation 8 de l'enceinte de transport 2 de manière étanche et en ouvrant les clapets anti-retour entrant 11 éventuellement présents.

La tête obstruante 24 comporte un élément d'étanchéité borgne 32, configuré pour être au moins partiellement comprimé ou déformé pour obturer un port de ventilation 9 de l'enceinte de transport 2 lorsque l'enceinte de transport 2 est accouplée à l'interface 20.

L'élément d'étanchéité borgne 32 est par exemple au moins partiellement en matériau élastique, tel qu'en silicone. C'est par exemple une ventouse (figure 3b), un joint torique ou un joint à lèvres ou un soufflet.

L'interface 20 peut comporter plusieurs têtes de mesure 23 et peut comporter plusieurs têtes obstruantes 24.

Ainsi, dans le premier exemple illustré par la figure 1 et la figure 2a où l'enceinte de transport 2 comporte deux ports d'entrée 8 et deux ports de sortie 9, l'interface 20 comporte deux têtes de mesure 23 et deux têtes obstruantes 24 (figure 3a et 3b), une tête de mesure 23 étant configurée pour s'engager dans un port d'entrée 8 respectif et une tête obstruante 24 étant configurée pour obturer un port de sortie 9 respectif.

Par ailleurs, lorsque l'enceinte de transport 2 est accouplée à l'interface 20, tous les ports de ventilation 8, 9 de l'enceinte de transport 2 sont accouplés à l'interface 20. Les ports de ventilation 8, 9 sont soit engagés par une tête de mesure 23, soit obturés par une tête obstruante 24, au moins une tête de mesure 23 étant engagée dans un port de ventilation 8. A l'état accouplé, les éléments d'étanchéité périphérique et borgne 31, 32 peuvent être au moins partiellement comprimés ou déformés.

Ainsi, toutes les fuites éventuelles de gaz autres que celles situées entre la porte 6 et l'enveloppe 4 sont maîtrisées, c'est à dire qu'elles sont soit obstruées, soit raccordées à une tête de mesure 23, de sorte que le contrôle d'étanchéité de l'enceinte de transport 2 reflète uniquement le contrôle de l'étanchéité de fermeture de la porte 6 de l'enceinte 2.

En outre, les têtes de mesure 23 permettent de maintenir les clapets anti-retour entrants 11 éventuellement présents en position ouverte, ce qui permet d'accéder à l'intérieur de l'enceinte de transport 2, sans modification et sans ouverture de celle-ci et pendant toute la durée d'un contrôle d'étanchéité.

L'interface 20 peut en outre comporter un moyen de positionnement 21, configuré pour positionner et supporter l'enceinte de transport 2.

Le moyen de positionnement 21 comporte par exemple trois pions de centrage 21a, 21b, 21c faisant saillie du plateau 25 de l'interface 20 (figure 3b). Les pions de centrage 21a, 21b, 21c sont configurés pour s'engager dans trois cavités complémentaires 16a, 16b, 16c, ménagées dans le fond 4a de l'enceinte de transport 2 (figure 2a) de manière à positionner et supporter l'enceinte de transport 2. Il s'agit d'un moyen de positionnement de la norme SEMI. En fonctionnement automatique, une enceinte de transport 2 peut être chargée sur une interface 20 par descente de l'enceinte de transport 2 sur les pions de centrage 21a, 21b, 21c, le contact de l'enceinte de transport 2 avec les pions 21a, 21b, 21c arrêtant la descente de l'enceinte de transport 2.

L'interface 20 peut en outre comporter au moins un moyen de maintien configuré pour maintenir l'enceinte de transport 2.

Le moyen de maintien comporte par exemple un doigt de maintien 22 mobile entre une position d'attente (figure 3a) et une position de maintien (figure 3b) dans laquelle le doigt 22 maintient l'enceinte de transport 2. Le doigt de maintien 22 est par exemple mobile en translation. Il est apte à s'engager dans une cavité de retenue 17 de forme complémentaire ménagée dans le fond 4a de l'enceinte de transport 2 (figure 2a) en position de maintien pour retenir axialement l'enceinte de transport 2.

L'interface 20 peut comporter des moyens de maintien différents et normés de manière à pouvoir maintenir différentes types d'enceintes de transport 2, ici à ouverture latérale.

L'interface 20 peut comporter un moyen de maintien comprenant une clé de verrouillage 26 mobile entre une position d'attente (figure 3a) et une position de maintien (figure 3b) dans laquelle la clé 26 maintient l'enceinte de transport 2. La clé de verrouillage 26 est mobile axialement et elle est apte à pivoter de 90° dans la position de maintien pour s'engager dans une cavité de retenue complémentaire ménagée dans le fond 4a de l'enceinte de transport 2.

Selon un exemple de réalisation, la au moins une tête de mesure 23 et la au moins une tête obstruante 24 sont fixes et font saillie d'un plateau 25 de l'interface 20. Ainsi, le positionnement de l'enceinte de transport 2 sur les au moins une tête de mesure 23 et obstruante 24 permet de positionner et d'accoupler l'enceinte de transport 2 à l'interface 20 en engageant la au moins une tête de mesure 23 dans un port de ventilation 8 et en obstruant au moins un port de ventilation 9 par une tête obstruante 24.

Lorsque l'interface 20 comporte un moyen de positionnement 21 et un moyen de maintien 22 et que les éléments d'étanchéité périphérique et borgne 31, 32 sont élastiques, les éléments d'étanchéité périphérique et borgne 31, 32 à l'état non comprimé ou non déformés, peuvent faire saille de l'interface 20 légèrement au-delà de l'extrémité du moyen de positionnement 21. Ainsi, le positionnement et le maintien de l'enceinte de transport 2 accouplée à l'interface 20 permettent d'engager au moins une tête de mesure 23 dans un port de ventilation 8 et d'obstruer au moins un port de ventilation 9 par une tête obstruante 24.

Selon un autre exemple de réalisation, le dispositif de contrôle 1 comporte au moins un actionneur de têtes 33, tel qu'un vérin, configuré pour déplacer la au moins une tête de mesure 23 et la au moins une tête obstruante 24 entre une position de retrait (figure 3a) et une position saillante de contrôle de l'étanchéité (figure 3b). Dans ce cas, l'interface 20 comporte de préférence un moyen de maintien 22 pour maintenir l'enceinte de transport 2 au moment du déplacement de l'actionneur 33.

La course de déplacement d de l'actionneur de têtes 33 dépend de la position des éléments d'étanchéité périphérique et borgne 31, 32 en position de retrait. Ceux-ci peuvent affleurer des trous 34 ménagés dans le plateau 25 de l'interface 20 ou être situés au-dessous du plateau 25 ou dépasser du plateau 25 en position de retrait.

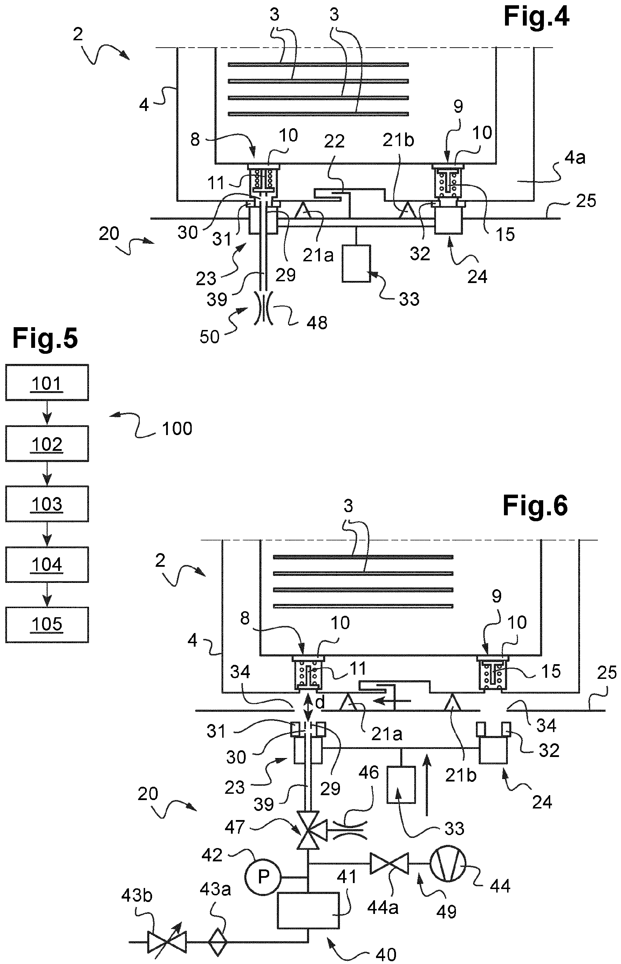

On prévoit par exemple que la course de déplacement d de l'actionneur 33 soit supérieure à 0.5mm (figure 6), ce qui permet à des éléments d'étanchéité périphérique et borgne 31, 32 affleurant le plateau 25 en position de retrait, d'être déplacés au-delà du moyen de positionnement 21 de manière à ouvrir au moins partiellement les clapets anti-retour entrants 11 quelque soit la raideur des organes élastiques 14, et éventuellement en comprimant ou déformant au moins partiellement les éléments d'étanchéité périphérique et borgne 31, 32.

Le dispositif de contrôle 1 peut comporter au moins une ligne de mesure 40 reliée à un embout 29 d'une tête de mesure 23. La ligne de mesure 40 comporte un dispositif de contrôle du débit 41 et/ou un capteur de pression 42.

Le dispositif de contrôle du débit 41 est par exemple un débitmètre massique réglable. Il permet l'injection contrôlée de différents flux de gaz, par exemple dans la gamme 0sccm-2000sccm, dans une canalisation 39 de la ligne de mesure 40 débouchant sur l'embout 29 de la tête de mesure 23.

Le capteur de pression 42 est par exemple apte à mesurer des pressions comprises entre 0 et 10 mbar dans la canalisation 39.

Le dispositif de contrôle du débit 41 est par exemple interposé entre l'embout 29 et un filtre à particules 43a agencé en aval d'un manodétendeur réglable 43b, lui-même agencé en aval d'une source de gaz de purge, dans la direction d'écoulement des gaz allant de la source de gaz vers le dispositif de contrôle du débit 41.

Le dispositif de contrôle du débit 41 et le capteur de pression 42 peuvent être agencés sur une même ligne de mesure 40 (figure 1). Dans le cas où le dispositif de contrôle 1 comporte deux têtes de mesure 23, le dispositif de contrôle du débit 41 peut être monté sur une première ligne de mesure 40 raccordée à un premier embout 29 et le capteur de pression 42 peut être monté sur une deuxième ligne de mesure 40 raccordée à un deuxième embout 29. Dans ces deux cas, la ligne de mesure 40 équipée du dispositif de contrôle du débit 41 et/ou du capteur de pression 42 est raccordée à une tête de mesure 23 destinée à s'engager dans un port de ventilation sans clapet ou un port d'entrée 8 muni d'un clapet anti-retour entrant 11.

Le dispositif de contrôle 1 peut comporter une ligne de prélèvement 49 reliée à l'embout 29 d'une tête de mesure 23 pour abaisser la pression dans la canalisation reliée à la tête de mesure 23.

La ligne de prélèvement 49 comprend une pompe de prélèvement 44, telle qu'une petite pompe à membrane, et une vanne d'isolation 44a. La pompe de prélèvement 44 est montée en aval de la vanne d'isolation 44a dans la direction d'écoulement des gaz, de manière à pouvoir isoler la pompe de prélèvement 44 de la tête de mesure 23.

La ligne de prélèvement 49 peut être montée en dérivation d'une ligne de mesure 40 comportant un dispositif de contrôle du débit 41 et/ou un capteur de pression 42. Il peut aussi s'agir d'une ligne distincte. La ligne de prélèvement 49 équipée d'une pompe de prélèvement 44 peut être raccordée à une tête de mesure 23 destinée à s'engager dans un port de ventilation sans clapet ou dans un port d'entrée 8 muni d'un clapet anti-retour entrant 11 ou dans un port de sortie 9 muni d'un clapet anti-retour sortant 15.

La pompe de prélèvement 44 permet de faciliter le contrôle de pression dans l'enceinte de transport 2, notamment en permettant d'atteindre plus rapidement une pression souhaitée lors d'un contrôle d'étanchéité de l'enceinte 2.

La ligne de mesure 40 peut également comporter au moins un orifice calibré d'auto-contrôle 46 monté en dérivation de la tête de mesure 23 ainsi qu'une vanne trois voies 47. L'orifice calibré d'auto-contrôle 46 peut comporter un filtre à particules.

La vanne trois voies 47 est apte à mettre en communication le dispositif de contrôle du débit 41 et le capteur de pression 42, et éventuellement la ligne de prélèvement 49, avec l'orifice calibré d'auto-contrôle 46 en étant isolé de la tête de mesure 23 pour le contrôle de la ligne de mesure 40 (flèche F1 sur la figure 1).

La vanne trois voies 47 est également apte à mettre en communication le dispositif de contrôle du débit 41 et le capteur de pression 42, et éventuellement la ligne de prélèvement 49, avec la tête de mesure 23 en étant isolé de l'orifice calibré d'auto-contrôle 46 pour le contrôle d'étanchéité de l'enceinte de transport 2 (flèche F2 sur la figure 1).

Le dispositif de contrôle 1 peut comporter une ligne d'étalonnage 50 reliée à un embout 29 d'une tête de mesure 23, la ligne d'étalonnage 50 comportant au moins un orifice calibré d'étalonnage 48 (figure 4). L'orifice calibré d'étalonnage 48 peut comporter un filtre à particules.

La ligne d'étalonnage 50 peut être montée en dérivation d'une ligne de mesure 40 comportant un dispositif de contrôle du débit 41 et/ou un capteur de pression 42, l'orifice calibré d'étalonnage 48 étant alors monté en amont d'une vanne. Il peut aussi s'agir d'une ligne distincte, comportant par exemple également une ligne de prélèvement 49. Dans ce cas, la tête de mesure 23 peut être pourvue d'un actionneur de tête 33 dédié, pour déplacer la tête de mesure 23 en position saillante uniquement lors d'une étape de calibration.

Cette ligne d'étalonnage 50 équipée d'un orifice calibré d'étalonnage 48 peut être raccordée à une tête de mesure 23 destinée à s'engager dans un port de ventilation sans clapet ou dans un port d'entrée 8 muni d'un clapet anti-retour entrant 11 pour s'assurer que le clapet reste ouvert le temps de la calibration.

La ligne d'étalonnage 50 permet ainsi de générer une fuite calibrée dans l'enceinte de transport 2 pour la calibration du dispositif de contrôle 1.

Le dispositif de contrôle 1 peut comporter plusieurs interfaces 20 pour le contrôle simultané de l'étanchéité de plusieurs enceintes de transport 2 accouplées à une interface 20 respective.

On va maintenant décrire un exemple de procédé de contrôle 100 de l'étanchéité d'une enceinte de transport 2 (figure 5) au moyen d'un dispositif de contrôle 1 comportant par exemple deux têtes de mesure 23 et deux têtes obstruantes 24, le dispositif de contrôle 10 comportant en outre un actionneur de têtes 33.

Le procédé de contrôle 100 peut comporter une étape d'auto-contrôle 101, dans laquelle on mesure la pression dans la ligne de mesure 40 raccordée à une fuite calibrée en étant isolé de la tête de mesure 23.

Pour cela, on met en communication le dispositif de contrôle du débit 41 et le capteur de pression 42 d'une ligne de mesure 40, et éventuellement la pompe de prélèvement 44, avec l'orifice calibré d'auto-contrôle 46, en étant isolé de la tête de mesure 23 (flèche F1 sur la figure 1).

L'étape d'auto-contrôle 101 de la ligne de mesure 40 peut être réalisée à tout moment, avec ou sans enceinte de transport 2 accouplée. Elle permet de vérifier le bon fonctionnement du dispositif de contrôle 1, ce qui permet d'éviter les erreurs d'interprétation des mesures de pression.

Les étapes ci-après du procédé de contrôle 100 nécessitent l'accouplement d'une enceinte de transport 2 à l'interface 20.

Pour cela, par exemple, on commence par positionner l'enceinte de transport 2 sur les pions de centrage 21a, 21b, 21c, le doigt de maintien 22 étant en position d'attente, les têtes de mesure 23 et les têtes obstruantes 24 étant en position de retrait (figure 3a).

Puis, on commande le déplacement du doigt de maintien 22 dans la position de maintien pour maintenir l'enceinte de transport 2 (figures 3b, 6).

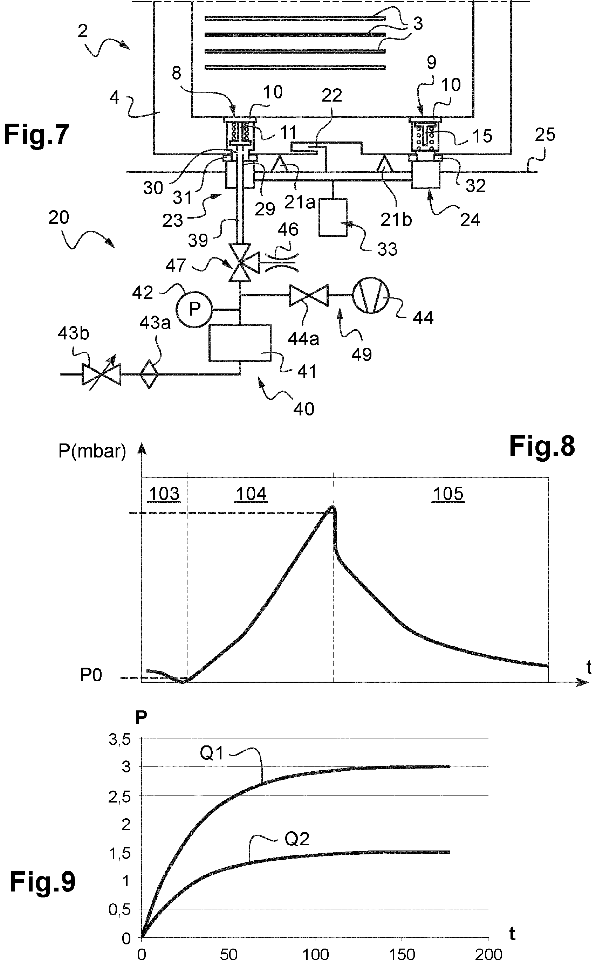

Puis, on commande le déplacement de l'actionneur de têtes 33 pour déplacer les têtes de mesure 23 et les têtes obstruantes 24 en position saillante de contrôle de l'étanchéité (figure 3b, 7).

L'engagement des têtes de mesure 23 dans un orifice 12 d'un port de ventilation 8 respectif de l'enceinte de transport 2 repousse l'obturateur mobile 13 des clapets anti-retour entrant 11 et déforme au moins partiellement les éléments d'étanchéité périphérique 31.

Les éléments d'étanchéité borgne 32 des têtes obstruantes 24 sont en outre au moins partiellement déformés et obturent un port de ventilation 9 respectif de l'enceinte de transport 2.

L'enceinte de transport 2 est alors accouplée à l'interface 20.

Les ports d'entrée 8 et les ports de sortie 9 de l'enceinte de transport 2 sont, soit engagés par une tête de mesure 23, soit obturés par une tête obstruante 24, au moins une tête de mesure 23 étant engagée dans un port de ventilation 8, les éléments d'étanchéité périphérique et borgne 31, 32 étant au moins partiellement déformés.

Le procédé de contrôle 100 peut comporter une étape de calibration 102 dans laquelle une ligne d'étalonnage 50 est raccordée à l'enceinte de transport 2 par une tête de mesure 23 pour générer une fuite calibrée (figure 4). On mesure la pression dans une ligne de mesure 40 raccordée à une tête de mesure 23 engagée dans un port de ventilation 8 de l'enceinte de transport 2 accouplée à l'interface 20.

Cette étape de calibration 102 permet notamment d'ajuster les valeurs théoriques de fuites déduites des mesures de pression, avec les données en situation réelle, notamment pour ne pas prendre en compte les déformations de l'enceinte de transport 2 en surpression. L'étape de calibration 102 peut être effectuée au démarrage du dispositif de contrôle 1, puis régulièrement.

Le procédé de contrôle 100 peut comprendre une étape préalable de conditionnement 103, dans laquelle on établit une pression initiale prédéterminée P0 dans la ligne de mesure 40 raccordée à une tête de mesure 23 engagée dans un port de ventilation 8 de l'enceinte de transport 2 accouplée à l'interface 20. La pression initiale prédéterminée P0 peut être établie au moyen de la pompe de prélèvement 44 et du dispositif de contrôle du débit 41.

Les mesures réalisées sur une même enceinte de transport 2 présentent alors une bonne répétabilité. Les mesures réalisées sur différentes enceintes de transport 2 peuvent alors être comparées entre elles, ce qui facilite l'interprétation à donner aux résultats. En outre, la pompe de prélèvement 44 permet un contrôle aisé et rapide de la pression initiale prédéterminée P0, ce qui permet de ne pas perdre en cadence de production. Cette étape de conditionnement 103 peut être réitérée à chaque nouveau contrôle d'étanchéité.

Le contrôle d'étanchéité de l'enceinte de transport 2 proprement dit, peut être réalisé principalement de deux manières.

Selon un premier exemple, on met l'atmosphère interne de l'enceinte de transport 2 en surpression, c'est-à-dire à une pression supérieure à la pression atmosphérique de quelques millibars en injectant un flux de gaz contrôlé dans une tête de mesure 23 engagée dans un port de ventilation 8 de l'enceinte de transport 2 accouplée à l'interface 20 (étape de montée en pression 104, figure 8).

Puis on arrête l'injection et on mesure la descente en pression dans une ligne de mesure 40 d'une tête de mesure 23 engagée dans un port de ventilation 8 (étape de descente en pression 105).

La courbe temporelle de descente en pression permet de déterminer la conductance d'un flux de fuite. Plus la descente en pression est rapide et plus la fuite est importante. Cette méthode est sensible et particulièrement adaptée aux fuites faibles, telles que de l'ordre de 0,1l/s. La mesure de la descente en pression au cours du temps est possible grâce au maintien ouvert des clapets anti-retour entrants 11 par les têtes de mesure 23 pendant toute la durée du contrôle.

Selon un deuxième exemple, on injecte un flux de gaz constant dans une tête de mesure 23 engagée dans un port de ventilation 8 de l'enceinte de transport 2 accouplée à l'interface 20 et on mesure l'évolution de la pression au cours du temps dans la ligne de mesure 40 (figure 9).

L'évolution de la pression en fonction du temps et du flux de gaz injecté permet de déterminer un flux de fuite. Cette méthode permet de mesurer de plus grosses fuites, telles que de l'ordre de quelques l/s.

Le maintien ouvert des clapets anti-retour entrants 11 par les têtes de mesure 23 permet d'injecter des flux de gaz contrôlés en s'affranchissant de la variabilité des organes élastiques 14 des clapets qui pourraient augmenter l'incertitude des mesures, la raideur des organes élastiques 14 présentant de fortes dispersions d'une enceinte de transport 2 à l'autre. Ce maintien des clapets permet également d'éviter les effets de vibration des clapets lorsque ceux-ci sont dans un état instable entre la position ouverte et la position fermée.

Le dispositif de contrôle 1 permet ainsi de contrôler l'étanchéité de l'enceinte de transport 2 au niveau du joint d'étanchéité périphérique 7, en ayant accès à l'atmosphère intérieure de l'enceinte de transport 2 depuis l'extérieur de l'enceinte de transport 2, sans modification de l'enceinte 2 qui reste standard, que l'enceinte de transport 2 comporte ou non des clapets anti-retour 11, 15. L'enceinte de transport 2 peut donc être contrôlée en cours de production, de manière entièrement automatisée et alors qu'elle contient des substrats semi-conducteurs 3.

## Revendications

1. Dispositif de contrôle (1) de l'étanchéité d'au moins une enceinte de transport (2) pour le convoyage et le stockage atmosphérique de substrats semi-conducteurs (3), ladite enceinte de transport (2) comprenant au moins deux ports de ventilation (8, 9), le dispositif de contrôle (1) comportant au moins une interface (20) configurée pour s'accoupler à l'enceinte de transport (2), l'interface (20) comprenant :
- au moins deux têtes de connexion (23, 24), au moins une tête de connexion étant formée par une tête de mesure (23) configurée pour s'engager dans un port de ventilation (8) de l'enceinte de transport (2), la tête de mesure (23) comprenant :
- un embout (29) saillant, débouchant par au moins un orifice (30), et
- un élément d'étanchéité périphérique (31) entourant l'embout (29),
- les têtes de connexion (23, 24) étant configurées pour s'accoupler à tous les ports de ventilation (8, 9) de l'enceinte de transport (2),
**caractérisé en ce que** le dispositif de contrôle (1) comporte au moins une ligne de mesure (40) reliée à un embout (29) d'une tête de mesure (23), la ligne de mesure (40) comportant un dispositif de contrôle du débit (41) et un capteur de pression (42), au moins une tête de connexion étant formée par une tête obstruante (24) comportant un élément d'étanchéité borgne (32) configuré pour obturer un port de ventilation (9) de l'enceinte de transport (2), tous les ports de ventilation (8, 9) de l'enceinte de transport (2) étant soit engagés par une tête de mesure (23), soit obturés par une tête obstruante (24).

2. Dispositif de contrôle (1) selon la revendication précédente, **caractérisé en ce que** le au moins un élément d'étanchéité périphérique (31) est élastique et au moins partiellement comprimé ou déformé lorsque l'enceinte de transport (2) est accouplée à l'interface (20).

3. Dispositif de contrôle (1) selon l'une des revendications précédentes, **caractérisée en ce que** l'interface (20) comporte au moins un moyen de maintien (22, 26) configuré pour maintenir l'enceinte de transport (2).

4. Dispositif de contrôle (1) selon l'une des revendications précédentes, **caractérisé en ce que** les têtes de connexion (23, 24) sont mobiles, l'interface (20) comportant en outre au moins un actionneur de têtes (33) configuré pour déplacer les têtes de connexion (23, 24) entre une position de retrait et une position saillante de contrôle de l'étanchéité.

5. Dispositif de contrôle (1) selon l'une des revendications 1 à 3, **caractérisé en ce que** les têtes de connexion (23, 24) sont fixes et font saillie de l'interface (20).

6. Dispositif de contrôle (1) selon l'une des revendications précédentes, **caractérisé en ce que** l'élément d'étanchéité périphérique (31) comporte une ventouse.

7. Dispositif de contrôle (1) selon l'une des revendications précédentes, **caractérisé en ce que** l'interface (20) comporte deux têtes de mesure (23) et deux têtes obstruantes (24).

8. Dispositif de contrôle (1) selon l'une des revendications précédentes, **caractérisé en ce que** la ligne de mesure (40) comporte au moins un orifice calibré d'auto-contrôle (46) monté en dérivation de la tête de mesure (23) et une vanne trois voies (47) apte à mettre en communication le dispositif de contrôle du débit (41) et le capteur de pression (42) de la ligne de mesure (40) avec le au moins un orifice calibré d'auto-contrôle (46) en étant isolé de la tête de mesure (23).

9. Dispositif de contrôle (1) selon l'une des revendications précédentes, **caractérisé en ce qu'**il comporte une ligne de prélèvement (49) reliée à l'embout (29) d'une tête de mesure (23), la ligne de prélèvement (49) comportant une pompe de prélèvement (44).

10. Dispositif de contrôle (1) selon l'une des revendications précédentes, **caractérisé en ce qu'**il comporte une ligne d'étalonnage (50) reliée à l'embout (29) d'une tête de mesure (23), la ligne d'étalonnage (50) comportant au moins un orifice calibré d'étalonnage (48).

11. Procédé de contrôle (100) de l'étanchéité d'au moins une enceinte de transport (2) pour le convoyage et le stockage atmosphérique de substrats semi-conducteurs (3) au moyen d'un dispositif de contrôle (1) selon l'une des revendications précédentes, dans lequel on accouple une enceinte de transport (2) à une interface (20) du dispositif de contrôle (1) de manière à ce que tous les ports de ventilation (8, 9) de l'enceinte de transport (2) soient accouplés à une tête de connexion (23, 24) de l'interface (20), au moins une tête de connexion (23) étant formée par une tête de mesure (23) engagée dans un port de ventilation (8, 9) de l'enceinte de transport (2), le procédé comprenant les étapes suivantes: on injecte un flux de gaz contrôlé dans une ligne de mesure (40) raccordée à une tête de mesure (23) engagée dans un port de ventilation (8) de l'enceinte de transport (2) accouplée à l'interface (20), puis on arrête l'injection et on mesure la descente en pression dans la ligne de mesure (40).

12. Procédé de contrôle (100) selon la revendication précédente, dans lequel tous les ports de ventilation (8, 9) de l'enceinte de transport (2) sont, soit engagés par une tête de mesure (23), soit obturés par une tête obstruante (24) de l'interface (20), au moins une tête de connexion (24) formée par une tête obstruante (24) obturant un port de ventilation (9) de l'enceinte de transport (2).

13. Procédé de contrôle (100) selon l'une des revendications 11 ou 12, **caractérisé en ce que** le au moins un élément d'étanchéité périphérique (31) est au moins partiellement comprimé ou déformé lorsque l'enceinte de transport (2) est accouplée à l'interface (20).

14. Procédé de contrôle (100) selon l'une des revendications 11 à 13, **caractérisé en ce qu'**il comprend une étape préalable de conditionnement (103) dans laquelle on établit une pression initiale prédéterminée (P0) dans une ligne de mesure (40) raccordée à une tête de mesure (23) engagée dans un port de ventilation (8) de l'enceinte de transport (2) accouplée à l'interface (20).

15. Procédé de contrôle (100) selon l'une des revendications 11 à 14, **caractérisé en ce qu'**il comporte une étape de calibration (102) dans laquelle une ligne d'étalonnage (50) est raccordée à l'enceinte de transport (2) par une tête de mesure (23) engagée dans un port de ventilation (8) de l'enceinte de transport (2) accouplée à l'interface (20) pour générer une fuite calibrée et on mesure la pression dans une ligne de mesure (40) raccordée à une tête de mesure (23) engagée dans un port de ventilation (8) de l'enceinte de transport (2) accouplée à l'interface (20).

16. Procédé de contrôle (100) selon l'une des revendications 11 à 15, **caractérisé en ce qu'**il comporte une étape d'auto-contrôle (101) dans laquelle on mesure la pression dans une ligne de mesure (40) comportant un orifice calibré d'auto-contrôle (46) monté en dérivation de la tête de mesure (23), l'orifice calibré d'auto-contrôle (46) étant mis en communication avec le dispositif de contrôle du débit (41) et le capteur de pression (42) de la ligne de mesure (40) en étant isolé de la tête de mesure (23).

## Patentansprüche

1. Vorrichtung (1) zur Kontrolle der Dichtheit mindestens eines Transportbehälters (2) zur Beförderung und atmosphärischen Lagerung von Halbleitersubstraten (3), wobei der Transportbehälter (2) mindestens zwei Belüftungsanschlüsse (8, 9) enthält, wobei die Kontrollvorrichtung (1) mindestens eine Verbindungsfläche (20) aufweist, die konfiguriert ist, an den Transportbehälter (2) gekoppelt zu werden, wobei die Verbindungsfläche (20) enthält:
- mindestens zwei Verbindungsköpfe (23, 24), wobei mindestens ein Verbindungskopf von einem Messkopf (23) gebildet wird, der konfiguriert ist, sich in einen Belüftungsanschluss (8) des Transportbehälters (2) einzuführen, wobei der Messkopf (23) enthält:
- ein vorstehendes Anschlussstück (29), das durch mindestens eine Öffnung (30) mündet, und
- ein das Anschlussstück (29) umgebendes Umfangsdichtelement (31),
- wobei die Verbindungsköpfe (23, 24) konfiguriert sind, an alle Belüftungsanschlüsse (8, 9) des Transportbehälters (2) gekoppelt zu werden,
**dadurch gekennzeichnet, dass** die Kontrollvorrichtung (1) mindestens eine Messleitung (40) aufweist, die mit einem Anschlussstück (29) eines Messkopfs (23) verbunden ist, wobei die Messleitung (40) eine Kontrollvorrichtung des Durchsatzes (41) und einen Drucksensor (42) aufweist, wobei mindestens ein Verbindungskopf von einem verschließenden Kopf (24) gebildet wird, der ein einseitig offenes Dichtelement (32) aufweist, das konfiguriert ist, einen Belüftungsanschluss (9) des Transportbehälters (2) zu verschließen, wobei in alle Belüftungsanschlüsse (8, 9) des Transportbehälters (2) entweder ein Messkopf (23) eingreift oder sie von einem verschließenden Kopf (24) verschlossen werden.

2. Kontrollvorrichtung (1) nach dem vorhergehenden Anspruch, **dadurch gekennzeichnet, dass** das mindestens eine Umfangsdichtelement (31) elastisch ist und mindestens teilweise zusammengedrückt oder verformt wird, wenn der Transportbehälter (2) an die Verbindungsfläche (20) gekoppelt wird.

3. Kontrollvorrichtung (1) nach einem der vorhergehenden Ansprüche, **dadurch gekennzeichnet, dass** die Verbindungsfläche (20) mindestens eine Halteeinrichtung (22, 26) aufweist, die konfiguriert ist, den Transportbehälter (2) zu halten.

4. Kontrollvorrichtung (1) nach einem der vorhergehenden Ansprüche, **dadurch gekennzeichnet, dass** die Verbindungsköpfe (23, 24) beweglich sind, wobei die Verbindungsfläche (20) außerdem mindestens einen Stellantrieb von Köpfen (33) aufweist, der konfiguriert ist, die Verbindungsköpfe (23, 24) zwischen einer zurückgezogenen Stellung und einer vorstehenden Stellung der Kontrolle der Dichtheit zu verschieben.

5. Kontrollvorrichtung (1) nach einem der Ansprüche 1 bis 3, **dadurch gekennzeichnet, dass** die Verbindungsköpfe (23, 24) ortsfest sind und von der Verbindungsfläche (20) vorstehen.

6. Kontrollvorrichtung (1) nach einem der vorhergehenden Ansprüche, **dadurch gekennzeichnet, dass** das Umfangsdichtelement (31) einen Saugnapf aufweist.

7. Kontrollvorrichtung (1) nach einem der vorhergehenden Ansprüche, **dadurch gekennzeichnet, dass** die Verbindungsfläche (20) zwei Messköpfe (23) und zwei verschließende Köpfe (24) aufweist.

8. Kontrollvorrichtung (1) nach einem der vorhergehenden Ansprüche, **dadurch gekennzeichnet, dass** die Messleitung (40) mindestens eine kalibrierte Eigenkontrollöffnung (46), die in Abzweigung vom Messkopf (23) montiert ist, und ein Dreiwegeventil (47) aufweist, das fähig ist, die Kontrollvorrichtung des Durchsatzes (41) und den Drucksensor (42) der Messleitung (40) mit der mindestens einen kalibrierten Eigenkontrollöffnung (46) in Verbindung zu bringen, indem sie vom Messkopf (23) isoliert ist.

9. Kontrollvorrichtung (1) nach einem der vorhergehenden Ansprüche, **dadurch gekennzeichnet, dass** sie eine Entnahmeleitung (49) aufweist, die mit dem Anschlussstück (29) eines Messkopfs (23) verbunden ist, wobei die Entnahmeleitung (49) eine Entnahmepumpe (44) aufweist.

10. Kontrollvorrichtung (1) nach einem der vorhergehenden Ansprüche, **dadurch gekennzeichnet, dass** sie eine Kalibrierleitung (50) aufweist, die mit dem Anschlussstück (29) eines Messkopfs (23) verbunden ist, wobei die Kalibrierleitung (50) mindestens eine kalibrierte Kalibrieröffnung (48) aufweist.

11. Verfahren zur Kontrolle (100) der Dichtheit mindestens eines Transportbehälters (2) zur Beförderung und atmosphärischen Lagerung von Halbleitersubstraten (3) mittels einer Kontrollvorrichtung (1) nach einem der vorhergehenden Ansprüche, wobei ein Transportbehälter (2) so an eine Verbindungsfläche (20) der Kontrollvorrichtung (1) gekoppelt wird, dass alle Belüftungsanschlüsse (8, 9) des Transportbehälters (2) an einen Verbindungskopf (23, 24) der Verbindungsfläche (20) gekoppelt sind, wobei mindestens ein Verbindungskopf (23) von einem Messkopf (23) gebildet wird, der in einen Belüftungsanschluss (8, 9) des Transportbehälters (2) eingeführt ist, wobei das Verfahren die folgenden Schritte enthält:
ein kontrollierter Gasstrom wird in eine Messleitung (40) eingespeist, die an einen Messkopf (23) angeschlossen ist, der in einen Belüftungsanschluss (8) des Transportbehälters (2) eingeführt ist, der an die Verbindungsfläche (20) gekoppelt ist, dann wird die Einspeisung angehalten und der Druckabfall in der Messleitung (40) gemessen.

12. Kontrollverfahren (100) nach dem vorhergehenden Anspruch, wobei in alle Belüftungsanschlüsse (8, 9) des Transportbehälters (2) entweder ein Messkopf (23) eingeführt ist oder sie von einem verschließenden Kopf (24) der Verbindungsfläche (20) verschlossen werden, wobei mindestens ein von einem verschließenden Kopf (24) gebildeter Verbindungskopf (24) einen Belüftungsanschluss (9) des Transportbehälters (2) verschließt.

13. Kontrollverfahren (100) nach einem der Ansprüche 11 oder 12, **dadurch gekennzeichnet, dass** das mindestens eine Umfangsdichtelement (31) zumindest teilweise zusammengedrückt oder verformt wird, wenn der Transportbehälter (2) an die Verbindungsfläche (20) gekoppelt wird.

14. Kontrollverfahren (100) nach einem der Ansprüche 11 bis 13, **dadurch gekennzeichnet, dass** es einen vorhergehenden Schritt der Verpackung (103) enthält, in dem ein vorbestimmter Anfangsdruck (P0) in einer Messleitung (40) aufgebaut wird, die an einen Messkopf (23) angeschlossen ist, der in einen Belüftungsanschluss (8) des Transportbehälters (2) eingeführt ist, der an die Verbindungsfläche (20) gekoppelt ist.

15. Kontrollverfahren (100) nach einem der Ansprüche 11 bis 14, **dadurch gekennzeichnet, dass** es einen Kalibrierungsschritt (102) aufweist, in dem eine Kalibrierungsleitung (50) an den Transportbehälter (2) durch einen Messkopf (23) angeschlossen wird, der in einen Belüftungsanschluss (8) des Transportbehälters (2) eingeführt wird, der an die Verbindungsfläche (20) gekoppelt ist, um ein kalibriertes Leck zu erzeugen, und der Druck in einer an einen Messkopf (23) angeschlossenen Messleitung (40) gemessen wird, der in einen Belüftungsanschluss (8) des Transportbehälters (2) eingeführt ist, der an die Verbindungsfläche (20) gekoppelt ist.

16. Kontrollverfahren (100) nach einem der Ansprüche 11 bis 15, **dadurch gekennzeichnet, dass** es einen Schritt der Eigenkontrolle (101) aufweist, in dem der Druck in einer Messleitung (40) gemessen wird, die eine kalibrierte Eigenkontrollöffnung (46) aufweist, die in Abzweigung vom Messkopf (23) montiert ist, wobei die kalibrierte Eigenkontrollöffnung (46) mit der Kontrollvorrichtung des Durchsatzes (41) und dem Drucksensor (42) der Messleitung (40) in Verbindung gebracht wird, indem sie vom Messkopf (23) isoliert ist.

## Claims

1. Device (1) for monitoring the leaktightness of at least one transport enclosure (2) for the atmospheric conveyance and storage of semiconductor substrates (3), said transport enclosure (2) comprising at least two ventilation ports (8, 9), the monitoring device (1) having at least one interface (20) configured to be coupled to the transport enclosure (2), the interface (20) comprising:
- at least two connection heads (23, 24), at least one connection head being formed by a measurement head (23) configured to engage in a ventilation port (8) of the transport enclosure (2), the measurement head (23) comprising:
- a projecting end piece (29), opening through at least one orifice (30), and
- a peripheral sealing element (31) surrounding the end piece (29),
- the connection heads (23, 24) being configured to be coupled to all the ventilation ports (8, 9) of the transport enclosure (2),
**characterized in that** the monitoring device (1) has at least one measurement line (40) connected to an end piece (29) of a measurement head (23), the measurement line (40) having a device for monitoring the flow rate (41) and a pressure sensor (42), at least one connection head being formed by an obstructing head (24) having a blind sealing element (32) configured to close off a ventilation port (9) of the transport enclosure (2), all the ventilation ports (8, 9) of the transport enclosure (2) being either engaged by a measurement head (23) or closed off by an obstructing head (24).

2. Monitoring device (1) according to the preceding claim, **characterized in that** the at least one peripheral sealing element (31) is elastic and at least partially compressed or deformed when the transport enclosure (2) is coupled to the interface (20).

3. Monitoring device (1) according to either of the preceding claims, **characterized in that** the interface (20) has at least one securing means (22, 26) configured for securing the transport enclosure (2).

4. Monitoring device (1) according to one of the preceding claims, **characterized in that** the connection heads (23, 24) are mobile, the interface (20) also having at least one head actuator (33) configured to move the connection heads (23, 24) between a withdrawn position and a projecting position for monitoring the leaktightness.

5. Monitoring device (1) according to one of Claims 1 to 3, **characterized in that** the connection heads (23, 24) are fixed and project from the interface (20).

6. Monitoring device (1) according to one of the preceding claims, **characterized in that** the peripheral sealing element (31) has a suction cup.

7. Monitoring device (1) according to one of the preceding claims, **characterized in that** the interface (20) has two measurement heads (23) and two obstructing heads (24).

8. Monitoring device (1) according to one of the preceding claims, **characterized in that** the measurement line (40) has at least one calibrated self-monitoring orifice (46) mounted as a branch from the measurement head (23) and a three-way valve (47) that is able to put the device for monitoring the flow rate (41) and the pressure sensor (42) of the measurement line (40) into communication with the at least one calibrated self-monitoring orifice (46) while being isolated from the measurement head (23).

9. Monitoring device (1) according to one of the preceding claims, **characterized in that** it has a sampling line (49) connected to the end piece (29) of a measurement head (23), the sampling line (49) having a sampling pump (44) .

10. Monitoring device (1) according to one of the preceding claims, **characterized in that** it has a calibration line (50) connected to the end piece (29) of a measurement head (23), the calibration line (50) having at least one calibrated calibration orifice (48).

11. Method (100) for monitoring the leaktightness of at least one transport enclosure (2) for the atmospheric conveyance and storage of semiconductor substrates (3) by means of a monitoring device (1) according to one of the preceding claims, wherein a transport enclosure (2) is coupled to an interface (20) of the monitoring device (1) such that all the ventilation ports (8, 9) of the transport enclosure (2) are coupled to a connection head (23, 24) of the interface (20), at least one connection head (23) being formed by a measurement head (23) engaged in a ventilation port (8, 9) of the transport enclosure (2), the method comprising the following steps: a controlled gas flow is injected into a measurement line (40) connected to a measurement head (23) engaged in a ventilation port (8) of the transport enclosure (2) coupled to the interface (20), and then the injection is stopped and the fall in pressure in the measurement line (40) is measured.

12. Monitoring method (100) according to the preceding claim, wherein all the ventilation ports (8, 9) of the transport enclosure (2) are either engaged by a measurement head (23) or closed off by an obstructing head (24) of the interface (20), at least one connection head (24) formed by an obstructing head (24) closing off a ventilation port (9) of the transport enclosure (2).

13. Monitoring method (100) according to either of Claims 11 and 12, **characterized in that** the at least one peripheral sealing element (31) is at least partially compressed or deformed when the transport enclosure (2) is coupled to the interface (20).

14. Monitoring method (100) according to one of Claims 11 to 13, **characterized in that** it comprises a preliminary conditioning step (103) in which a predetermined initial pressure (P0) is established in a measurement line (40) connected to a measurement head (23) engaged in a ventilation port (8) of the transport enclosure (2) coupled to the interface (20).

15. Monitoring method (100) according to one of Claims 11 to 14, **characterized in that** it involves a calibration step (102) in which a calibration line (50) is connected to the transport enclosure (2) by a measurement head (23) engaged in a ventilation port (8) of the transport enclosure (2) coupled to the interface (20) so as to generate a calibrated leak, and the pressure is measured in a measurement line (40) connected to a measurement head (23) engaged in a ventilation port (8) of the transport enclosure (2) coupled to the interface (20).

16. Monitoring method (100) according to one of Claims 11 to 15, **characterized in that** it involves a self-monitoring step (101) in which the pressure is measured in a measurement line (40) having a calibrated self-monitoring orifice (46) mounted as a branch from the measurement head (23), the calibrated self-monitoring orifice (46) being put into communication with the device for monitoring the flow rate (41) and the pressure sensor (42) of the measurement line (40), while being isolated from the measurement head (23).
